# EUROPEAN PATENT APPLICATION

(11) **EP 1 128 440 A2**
(43) Date of publication of application: **29.08.2001**
(21) Application number: 01301158.0
(22) Date of filing: 09.02.2001
(51) Int. Cl.: H01L 29/06

(54) **Semiconductor junction profile and method for the production thereof**

(30) Priority: 21.02.2000 GB 0004050
(71) Applicant: Westcode Semiconductors Limited, Bristol, BS99 7QQ (GB)
(72) Inventor: Garrett, John Mansell, Chippenham, Wiltshire SN14 6DL (GB)
(74) Representative: Newstead, Michael John

(57) **Abstract**

A planar slice (1) of semiconductor substrate material of a first conductivity type is provided on one face with a first region (13a) of a second conductivity type having a higher dopant concentration than that of the substrate and on the opposite face a second region (13b) of said second conductivity type having a higher dopant concentration than that of the substrate. Each of the faces has had removed from part of it a depth of material which increases gradually as the outer edge is approached so that the junction between each of the regions (13a, 13b) and the substrate is exposed along a path following the shape of the perimeter of the slice but so that the removal of material ceases at a distance outwardly beyond the exposure of the junction to leave a rim (11) of the original planar faces of the slice at its perimeter.

## Description

The importance of terminating correctly the edge surface region of a semiconductor junction intended for operation in the reverse bias mode is well known. A variety of advantageous surface profiles are described in the literature. The general objective of these profiles is to control the electric field at the surface to be less than the maximum value reached at some point in the bulk of the semiconductor material. Consequently, the limiting field at which avalanche breakdown occurs is then reached first in the bulk material where it can be safely accommodated. The particular type of advantageous termination to which the present invention relates is commonly known as the shallow negative bevel. A recitation of its particular advantages may be found in *"Thyristor Design and Realization"* by Paul D. Taylor, John Wiley & Sons Ltd., England, 1987. (See *"2.2.4.2 Mechanical bevelling",* pp 41-45).

The shallow negative bevel technique is often applied to one junction of a device while applying a positive bevel to a junction on the opposite face. This is a very suitable combination for devices consisting of a silicon slice soldered to a backing plate of a refractory metal, e.g. tungsten or molybdenum, the positive bevel being applied to the face soldered to the backing plate. However, it is becoming common to construct devices with a floating slice of semiconductor material, i.e. the slice is not soldered to a backing plate. In such cases it is desirable to apply the shallow bevel to both faces of the slice. The result is a slice that tapers off in thickness at the edge causing this to become the most fragile part of the slice while at the same time being the most exposed to possible damage from the stresses of handling. Most bevelling methods tend also to produce a sharp comer at the edge which is particularly susceptible to chipping. The stress limitations imposed by the fragility of the structure are an undesirable restrictive factor to be considered when working the semiconductor material to produce the desired form.

As prior art there may also be mentioned: GB-A-1 068 199; EP-A-0 396 326; FR-A-2 468 207; and US-A-4 680 615.

According to the present invention from one aspect, there is provided a planar slice of semiconductor substrate material of first a conductivity type provided at one face with a first region of a second conductivity type having a higher dopant concentration than that of the substrate and at the opposite face a second region of said second conductivity type, having a higher dopant concentration than that of the substrate, wherein each of said faces has had removed from part of it by abrasion a depth of material which increases gradually as the outer edge is approached so that the junction between each of said regions and the substrate is exposed along a path following the shape of the perimeter of the slice but so that the removal of material ceases at a distance outwardly beyond the exposure of the junction to leave a rim of the original planar faces of the slice at its perimeter.

According to the present invention from another aspect, there is provided a method of producing a semiconductor junction profile, comprising providing a planar slice of semiconductor substrate material of a first conductivity type provided at one face with a first region of a second conductivity type having a higher dopant concentration than that of the substrate and at the opposite face a second region of said second conductivity type, having a higher dopant concentration than that of the substrate, the method comprising removing from part of each of said faces by abrasion a depth of material which increases gradually as the outer edge is approached so that the junction between each of said regions and the substrate is exposed along a path following the shape of the perimeter of the slice but so that the removal of material ceases at a distance outwardly beyond the exposure of the junction to leave a rim of the original planar faces of the slice at its perimeter.

The slice may be a disc and the material of the slice may be silicon.

The edge of the slice may be rounded in section.

Said first and second regions of said second conductivity type may be formed by the diffusion of a dopant of said second conductivity type into the faces of the substrate so as to over-dope the original first conductivity type and form a junction therewith at a predetermined depth.

Said first and second regions of said second conductivity type may extend around the outer edge of the slice to form a surface region which is broken only where each of said junctions is exposed.

The gradual increase in depth of the removal of material may constitute an angle of less than 7° relative to the plane of the junction thereby exposed, for example in the range from 2° to 5°, such as about 3°.

The substrate material may be of n-type conductivity and the surface regions of p-type conductivity.

The present invention also comprises a slice according to the invention with the addition of further semiconductor regions and ohmically connected electrodes so as to form an operable electrical device.

The present invention will now be described, by way of example, with reference to the accompanying drawings, in which:-
Figure 1 shows in transverse section, the outer part of a floating silicon slice with two opposed semiconductor junctions terminated near the edge with a shallow negative bevel according to the prior art;
Figure 2 shows a similar slice but with the form of outer edge adapted according to an example of the invention; and
Figure 3 shows an alternative form of the outer edge providing further advantage over the form of Figure 2.

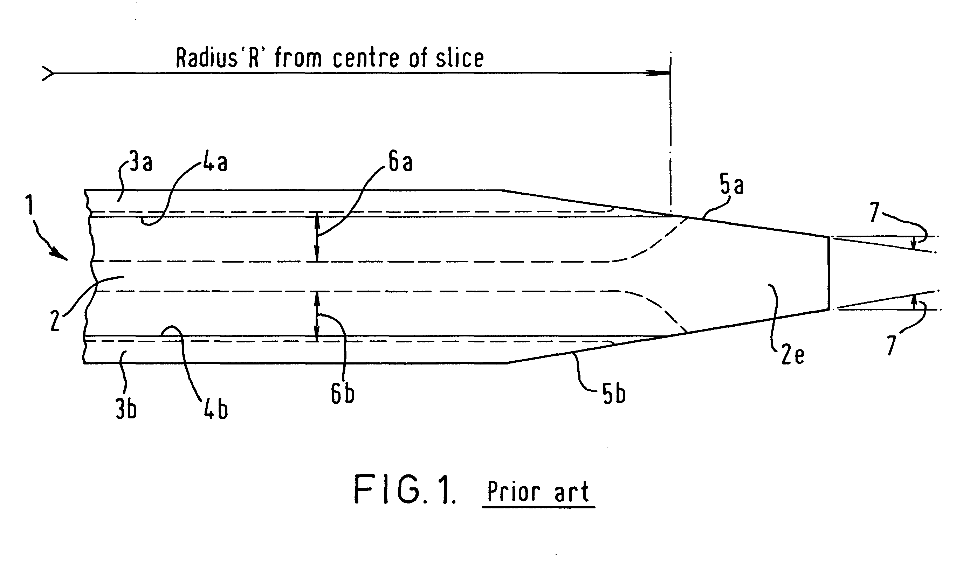

Referring now to Figure 1, there is represented a slice 1 of silicon consisting of three regions. A central substrate region 2 of high resistivity n-type silicon is sandwiched between two outer surface regions 3a, 3b each of lower resistivity p-type material. Typically, the surface regions 3a, 3b will have been formed by in-diffusion of a p-type dopant as is well known in the art, resulting in a gaussian or complementary error function concentration profile extending inwards of the surface to the junction with the substrate region 2. It is a general rule for the optimisation of the shallow negative bevel technique that the diffused-in concentration profile should be well graded rather than abrupt. The lines between the outer regions 3a, 3b and the central region 2 represent the respective semiconductor junctions 4a, 4b. It can be seen that the thinnest part of the slice 1 is the part beyond the emergence at the bevelled surfaces 5a, 5b of the junctions 4a, 4b. Space charge regions 6a, 6b build up around whichever of the respective junctions is in reverse bias mode. At high voltages the extents of the space charge regions 6a, 6b may overlap in the planar part of the slice, but for clarity they are shown here as they would behave at a moderate reverse bias for each junction. In the planar part of the slice these space charge regions extend mainly into the high resistivity substrate region 2 of the silicon disc. In contrast, at each of bevelled surfaces 5a and 5b the space charge region is constrained by the effect of the bevel angle 7, typically about 3°, to extend instead mainly into the respective diffused surface region 3a or 3b. A range of bevel angles in the range from 2° to 7° may be employed, smaller angles producing greater penetration of the space charge into the p-type surface region and being correspondingly appropriate to higher voltage designs. The effect of the space charge at each surface extending into the p-type surface region 3a or 3b, rather than into the substrate region 2, is that the edge part 2e of the substrate region lying beyond the extent of either of space charge regions 6a, 6b is never depleted of carriers and correspondingly remains always conductive. It is therefore never required to support an electric field but its potential is effectively tied to that of whichever junction has zero or forward bias. It follows that the exact shape of the slice in the region 2e is of no electrical consequence although, of course, it has a time varying potential and must be insulated.

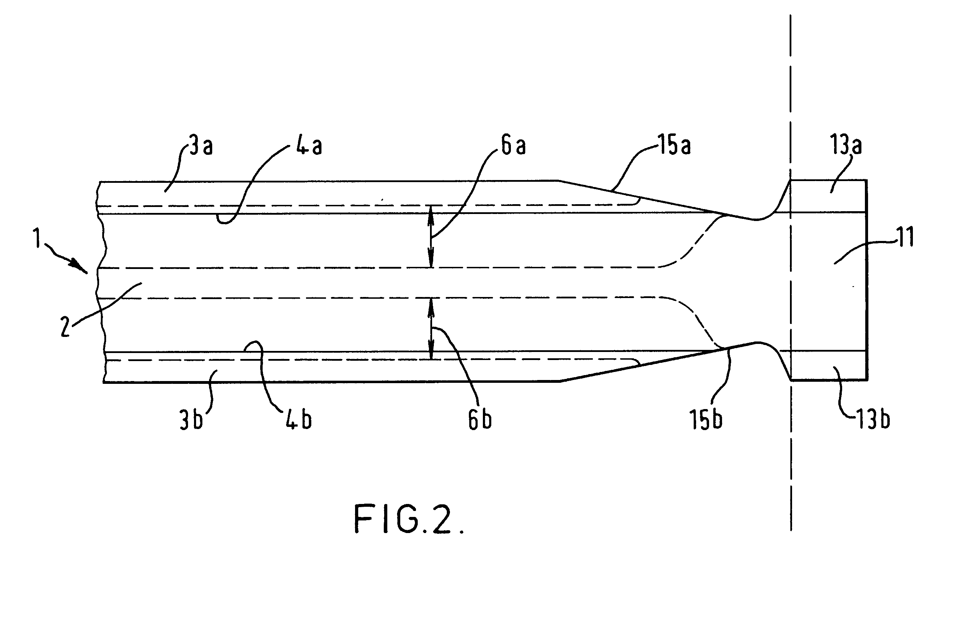

Turning now to Figure 2, wherein numerals previously used in Figure 1 retain the same meaning, there is shown a slice (at least 100mm in diameter) similar in all respects to Figure 1 except for the cessation of bevelled surfaces 15a, 15b before reaching the rim 11 of the slice 1 which thereby retains its original thickness. It can be seen that the extent of the space charge regions 6a, 6b associated with the respective junctions 4a, 4b is unaffected by the presence of the rim of full thickness silicon even though this now includes outer parts 13a, 13b of the diffused surface regions 3a, 3b that were removed in the formation of the prior art shape shown in Figure 1. The advantages secured by the structure of Figure 2 will now be described.

The normal method of forming the shape of Figure 1 is carefully and gently to abrade the silicon surface using a tool of complementary profile. Typically, this might be a section of a spherical bowl of accurately defined curvature so that the angle of the bevel where it exposes the junction 4a or 4b is at the desired value. The sine of the angle produced in this way is equal to the ratio of the radius R of the exposure line of the junction 4a or 4b to the radius of curvature of the bowl. The bowl may contain an abrasive slurry or its surface may be impregnated with an abrasive material, e.g. diamond. Of course there are other ways (grinding, sand-blasting) of abrading the surface to produce the same or a similar effect. However, the amount of reactive force that can safely be applied in the abrading procedure is limited by a combination of the mechanical strength of silicon and the extent to which its opposite face is effectively supported. Thus for forming the bevel angle of the surface 5a, surface 5b having not yet been shaped, the slice may be supported over the whole of the original opposite surface of region 3b or at least part of it facing the area of abrasion of surface 5a. This is not a difficult task as the face requiring support is, at this stage, flat. Effectively supporting the second face to be bevelled, the first face already having been shaped, poses a greater problem as the shape of the first formed bevel requires to be accurately followed. It is important not to apply a cantilevered flexing force to the silicon, particularly while lapping or grinding it, as this can very easily cause a stress fracture nucleated at a micro-scratch.

By way of contrast, in a device being made to the form shown in Figure 2, the bevelled surface 15a is ground to shape using an abrasive wheel while supporting the still flat surface of the opposite side. The process leaves the outer rim 11 with its original thickness. The slice is now turned over and the operation repeated on the second face while supporting the first face on each side of the area to be ground away, i.e. inwardly towards its centre and outwardly at the rim. The area of the silicon being worked on has now only to bridge between two areas of support resulting in compressive rather than tensile stresses in the surface area being abraded. The stress in the silicon material is thus more easily contained within safe limits.

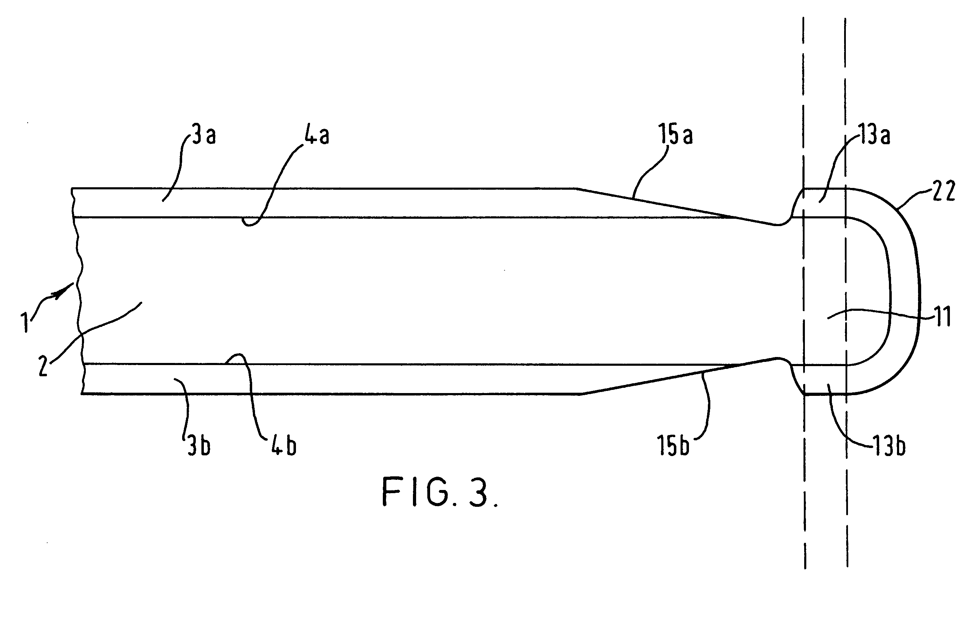

Referring now to Figure 3, there is shown the outer edge region of a slice prepared essentially as in Figure 2. Numerals used previously again have the same meaning as in Figures 1 and 2. The silicon slice has its outer edge surface 22 rounded so that external sharp corners are avoided. The edge may be rounded in the original slice before its several processing stages resulting in the outer parts of the diffused surface regions 13a, 13b being joined by a continuation around the edge of the slice as shown in the Figure, or it may be ground to shape shortly before the bevelling step. The advantage provided by the edge rounding, as is well known in the art, is a much enhanced resistance to mechanical damage such as chipping. This not only protects the slice itself but also avoids the generation of splinters of silicon which are detrimental to the general cleanliness of the work environment. The preservation of the rim thickness in the bevel method disclosed serves also to preserve the shape of the edge rounding which, if applied to the prior art technique, would be partially removed by the bevel extending to the edge of the slice and thereby become less effective.

It will be appreciated that the embodiments describe those features essential to the voltage blocking ability typical of a thyristor or gate turn-off device without reference to some of the other necessary features of these devices such as gate electrodes and additional emitter junctions. The invention is applicable generally to semiconductor devices of the floating type requiring two opposed blocking junctions as will be apparent to those skilled in the art, and is especially useful for slices at least 100mm in diameter.

## Claims

1. A planar slice of semiconductor substrate material of a first conductivity type provided at one face with a first region of a second conductivity type having a higher dopant concentration than that of the substrate and at the opposite face a second region of said second conductivity type having a higher dopant concentration than that of the substrate, wherein each of said faces has had removed from part of it by abrasion a depth of material which increases gradually as the outer edge is approached so that the junction between each of said regions and the substrate is exposed along a path following the shape of the perimeter of the slice but so that the removal of material ceases at a distance outwardly beyond the exposure of the junction to leave a rim of the original planar faces of the slice at its perimeter.

2. A slice according to claim 1, wherein the slice is a disc.

3. A slice according to claim 1 or 2, wherein the material of the slice is silicon.

4. A slice according to any preceding claim, wherein the edge of the slice is rounded in section.

5. A slice according to any preceding claim, wherein said first and second regions of said second conductivity type are formed by the diffusion of a dopant of said second conductivity type into the faces of the substrate so as to over-dope the original first conductivity type and form a junction therewith at a predetermined depth.

6. A slice according to any preceding claim, wherein said first and second regions of said second conductivity type extend around the outer edge of the slice to form a surface region which is broken only where each of said junctions is exposed.

7. A slice according to any preceding claim, wherein the gradual increase in depth of the removal of material constitutes an angle of less than 7° relative to the plane of the junction thereby exposed.

8. A slice according to claim 7, wherein said angle is in the range from 2° to 5°.

9. A slice according to claim 7, wherein said angle is about 3°.

10. A slice according to any preceding claim, wherein the substrate material is of n-type conductivity and the surface regions are of p-type conductivity.

11. A slice according to any preceding claim with the addition of further semiconductor regions and ohmically connected electrodes so as to form an operable electrical device.

12. A method of producing a semiconductor junction profile, comprising providing a planar slice of semiconductor substrate material of a first conductivity type provided at one face with a first region of a second conductivity type having a higher dopant concentration than that of the substrate and at the opposite face a second region of said second conductivity type, having a higher dopant concentration than that of the substrate, the method comprising removing from part of each of said faces by abrasion a depth of material which increases gradually as the outer edge is approached so that the junction between each of said regions and the substrate is exposed along a path following the shape of the perimeter of the slice but so that the removal of material ceases at a distance outwardly beyond the exposure of the junction to leave a rim of the original planar faces of the slice at its perimeter.

13. A method according to claim 12, wherein the slice is a disc.

14. A method according to claim 12 or 13, wherein the material of the slice is silicon.

15. A method according to any of claims 12 to 14, wherein the edge of the slice is rounded in section.

16. A method according to any of claims 12 to 15, wherein said first and second regions of said second conductivity type are formed by the diffusion of a dopant of said second conductivity type into the faces of the substrate so as to over-dope the original first conductivity type and form a junction therewith at a predetermined depth.

17. A method according to any of claims 12 to 16, wherein said first and second regions of said second conductivity type extend around the outer edge of the slice to form a surface region which is broken only where each of said junctions is exposed.

18. A method according to any of claims 12 to 17, wherein the gradual increase in depth of the removal of material constitutes an angle of less than 7° relative to the plane of the junction thereby exposed.

19. A method according to claim 18, wherein said angle is in the range from 2° to 5°.

20. A method according to claim 18, wherein said angle is about 3°.

21. A method according to any of claims 12 to 20, wherein the substrate material is of n-type conductivity and the surface regions are of p-type conductivity.
